Europäisches Patentamt

European Patent Office

Office européen des brevets

(19)

(11) Numéro de publication : **0 116 791**
**B1**

(12)

# FASCICULE DE BREVET EUROPÉEN

(45) Date de publication du fascicule du brevet :
**10.02.88**

(21) Numéro de dépôt : **83402291.5**

(22) Date de dépôt : **29.11.83**

(51) Int. Cl.⁴ : **H 01 L 25/04,** H 01 L 27/14,
H 01 L 31/18

(54) Procédé de fabrication d'un détecteur infrarouge matriciel à éclairage par la face avant.

(30) Priorité : 30.11.82 FR 8220031

(43) Date de publication de la demande :
29.08.84 Bulletin 84/35

(45) Mention de la délivrance du brevet :
10.02.88 Bulletin 88/06

(84) Etats contractants désignés :
DE GB IT NL

(56) Documents cités :
FR-A- 2 194 047
FR-A- 2 494 910
GB-A- 1 568 958
GB-A- 1 597 581
US-A- 3 661 741
US-A- 3 965 568

(73) Titulaire : **SOCIETE ANONYME DE TELECOMMUNI-
CATIONS (S.A.T.)**
**40 avenue de New York**
**F-75116 Paris (FR)**

(72) Inventeur : **Bourdillot, Michel Yves**
**41, rue Cantagrel**
**F-75624 Paris Cédex 13 (FR)**
Inventeur : **Gauthier, André**
**41, rue Cantagrel**
**F-75624 Paris Cédex 13 (FR)**
Inventeur : **Maille, Jacques Henri**
**41, rue Cantagrel**
**F-75624 Paris Cédex 13 (FR)**
Inventeur : **Pitault, Bernard Marcel**
**41, rue Cantagrel**
**F-75624 Paris Cédex 13 (FR)**

(74) Mandataire : **Bloch, Robert et al**
**6, rue du Faubourg Saint-Honoré**
**F-75008 Paris (FR)**

## Description

La présente invention concerne un procédé de fabrication d'un détecteur infrarouge matriciel, comprenant une matrice d'éléments infrarouges, notamment pour caméra, par exemple pour reconnaissance aérienne.

L'avantage de tels détecteurs à matrice réside dans le fait que l'adressage, ou le balayage, des éléments de la matrice s'effectue de manière électronique, et non plus mécaniquement par spot lumineux.

L'adressage consiste en fait, à l'aide de moyens électroniques de traitement, soit à intégrer les signaux délivrés par les éléments de la matrice, soit à commuter séquentiellement les éléments de la matrice sur un circuit de lecture des signaux délivrés. On conçoit donc que chacun des éléments de la matrice est connecté à ces moyens électroniques de traitement.

On a déjà proposé de coupler les éléments de la matrice à des circuits électroniques de traitement par des connexions. Mais cette solution présente des inconvénients dus à la longueur des lignes de connexion, dans lesquelles sont engendrés des bruits parasites, et à leur nombre qui provoque une charge thermique à cause des pertes en ligne. Par ailleurs, cette solution conduit à des modules de détection d'encombrement important, avec un grand nombre de soudures élémentaires.

On a ensuite proposé de fabriquer, selon le procédé classique en technologie îlot (island technology), un détecteur infrarouge matriciel en prenant une première plaquette de semi-conducteur de l'un des deux types p et n, préalablement découpée, en diffusant des zones de l'autre des deux types, depuis la face avant à éclairer de la plaquette, pour définir des jonctions et former une matrice de détecteurs élémentaires en disposant la première plaquette de détection sur une deuxième plaquette de semi-conducteur agencée pour traiter les signaux délivrés par les détecteurs élémentaires de la matrice de la première plaquette, et en formant, sur la face avant de la plaquette de détection, sur l'une des parois de celle-ci réunissant sa face avant et la face de la deuxième plaquette de traitement tournée vers la plaquette de détection, et sur cette face de la plaquette de traitement, des bornes de contact métalliques connectant lesdites zones de la plaquette de détection à des plages de métallisation associées de la plaquette de traitement (SPIE Vol. 225 IR Image Sensor Technology (1980), pages 26-33).

Un tel procédé de fabrication présente déjà l'avantage de pouvoir former les bornes de connexion collectivement en une seule opération.

Toutefois, ce procédé présente l'inconvénient selon lequel, avant la réalisation de ces bornes de connexion, les deux plaquettes de détection et de traitement doivent déjà être l'une sur l'autre. Il en résulte un risque de défaut d'alignement des bornes de connexion et des plages de métallisation de la plaquette de traitement. Il en résulte également un risque de discontinuité électrique dû à la discontinuité structurelle, au niveau du joint entre les deux plaquettes, généralement constitué de colle.

La présente invention vise donc à pallier ces inconvénients.

A cet effet, la présente invention concerne un procédé de fabrication d'un détecteur infrarouge matriciel à éclairage par la face avant, selon lequel on forme dans une première plaquette de semi-conducteur d'un premier type de conductivité depuis la face avant à éclairer, un relief constitué d'îlots séparés par des sillons, on diffuse dans le sommet des îlots des zones du second type de conductivité pour définir des jonctions p-n et former une matrice de détecteurs élémentaires, on dépose des bornes de contact métalliques en forme de bandes, contactant lesdites zones et s'étendant sur au moins l'une des parois des îlots jusque dans le sillon adjacent tout en étant isolées de cette paroi par une couche isolante, on amincit la plaquette de détection depuis sa face arrière jusqu'au niveau des sillons du relief et on dégage les bornes de contact, déposées dans ces sillons, on dispose la matrice de détecteurs, par sa face arrière de façon à établir une connexion électrique, sur une deuxième plaquette de semi-conducteur agencée pour traiter les signaux délivrés par les détecteurs élémentaires de la plaquette de détection, et on connecte lesdites bornes de contact à des plages de métallisation associées de la plaquette de traitement.

Ainsi, et grâce à l'invention, la formation des bornes de connexion dans les « sillons », au niveau bas du relief en îlots, de la plaquette de détection, ne pose pas de difficulté puisque la structure est continue, et tout risque de rupture électrique se trouve donc éliminé. En outre, un alignement parfait des bornes de connexion et des plages de métallisation de la plaquette de traitement peut être réalisé sans difficulté.

Enfin, le procédé de fabrication de l'invention est rapide et économique et n'entraîne aucune dégradation du matériau de la plaquette de détection.

Certes, la technique d'amincissement du matériau photodétecteur du procédé de l'invention était déjà connue par le document FR-A-2 494 910, qui d'ailleurs, enseignait également la formation d'un relief en îlots. Mais, selon le procédé de ce document antérieur, les jonctions sont formées avant que ne le soit le relief en îlots, et l'amincissement du substrat intervient avant la formation des bornes de contact, si bien que le résultat ou les avantages, tels que présentés ci-dessus, du procédé de la présente demande, avec ses îlots à profil assurant la continuité électrique des bornes de contact particulières ne sont pas procurés par ce procédé antérieur.

Dans une mise en oeuvre préférée du procédé de l'invention, on forme les bornes de contact par l'un des deux procédés d'évaporation thermique et de pulvérisation cathodique, avant de les grossir par voie électrolytique.

La présente invention sera mieux comprise à l'aide de la description suivante d'une mise en oeuvre préférée du procédé de l'invention, en référence aux dessins annexés, sur lesquels :

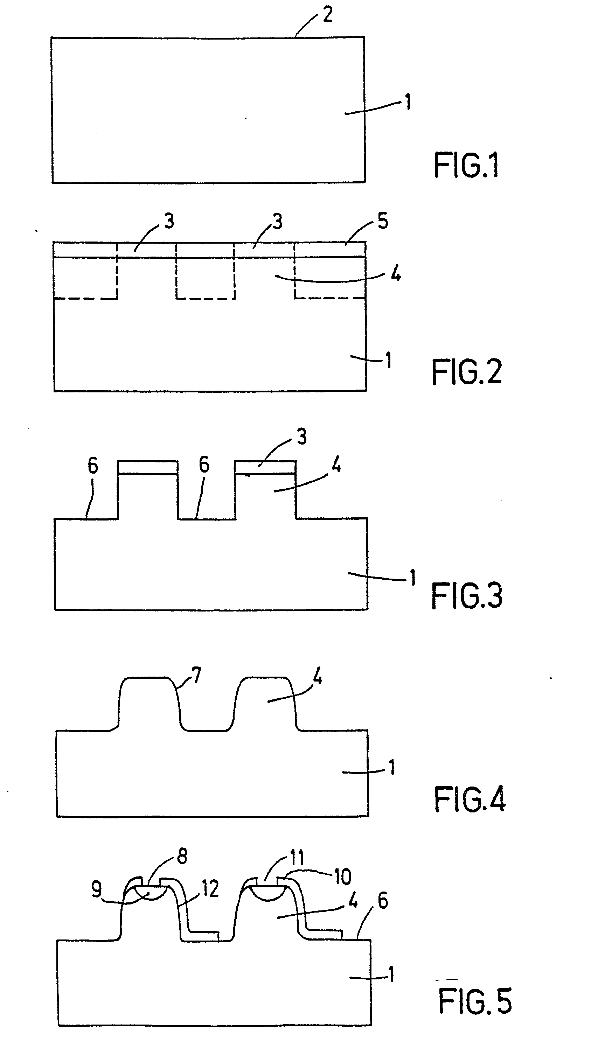

— les figures 1 à 9 représentent une vue en coupe schématique d'une plaquette de détection dans ses différentes phases de fabrication et de montage sur une plaquette de traitement, selon le procédé de l'invention, et

— la figure 10 représente une vue en perspective de l'ancrage sur la plaquette de détection d'une borne de contact de connexion du détecteur fabriqué selon le procédé de l'invention.

Vont donc maintenant être décrites les différentes phases du procédé de fabrication d'un détecteur infrarouge matriciel à éclairage par la face avant, par exemple en technologie planar.

On part d'un substrat massif 1, par exemple en Hg Cd Te, qui est un matériau semi-conducteur bien approprié, notamment pour la détection d'objets ou de paysages dans les bandes spectrales de 3 à 5 µm et de 8 à 12 µm, bien que l'invention ne soit pas limitée à un tel matériau. Le substrat 1 est plus précisément de type p, bien qu'on aurait pu également prendre un substrat de type n. Le substrat 1 se présente dès le départ sous forme d'une plaquette d'environ 1 mm d'épaisseur dans le cas considéré.

Le substrat 1 est poli et soumis à une attaque chimique afin d'obtenir des parois parfaitement planes et ayant un bon état de surface physico-chimique.

On dépose ensuite sur toute la face supérieure, ou avant, 2 de la plaquette 1, celle destinée à être éclairée, une couche 5 de résine photosensible puis on y applique un masque pourvu de lumières régulièrement espacées selon le motif désiré, et on insole aux rayons ultra-violets pour polymériser la résine, en l'espèce négative, au droit des lumières et former ainsi des îlots de réserve 3 devant résister à des agents d'attaque, et correspondant à des reliefs 4, à conserver.

On attaque depuis la couche de résine 5 le substrat 1 jusqu'à l'obtention d'une structure en relief présentant des îlots 4 et des sillons 6, entre les îlots 4. La hauteur des îlots 4 peut avantageusement être comprise entre 30 et 50 µm. L'attaque peut être réalisée par abrasion ionique ou encore par voie chimique, par exemple avec une solution de brome pur et d'alcool.

Après cette « découpe », on élimine les zones de réserve 3, à l'aide du solvant approprié.

On procède ensuite à un léger polissage pour adoucir la structure des îlots 4 et arrondir leurs bords 7.

Après avoir déposé une couche de masquage 10, en matériau diélectrique sur la face supérieure 8 des îlots 4, sur l'une de leurs parois 12 plus ou moins verticales, réunissant leurs niveaux haut et bas, et sur une partie des sillons 6, adjacents aux parois concernées, procédé, à la partie supérieure des îlots 4, à l'ouverture de fenêtres de diffusion 11 dans cette couche 10, par exemple par attaque chimique, on procède, à partir de ces fenêtres, à une diffusion de type n, depuis la face 8, pour obtenir des zones 9 de type n. Bien entendu, si on était parti d'un substrat de type n, on aurait procédé ensuite à une diffusion de type p.

On obtient ainsi, une série, ou mieux une mosaïque, de photodiodes élémentaires créées par les zones 9 de type n dans le substrat 1 de type p des îlots 4.

On dépose ensuite, à travers un masque, sur l'isolant 10, et depuis les zones 9, de fines bandes métalliques 13 de quelques centaines de nm d'épaisseur, qui s'étendent donc d'un côté des îlots 4, de la zone 9 au sillon 6 correspondant. Ce dépôt peut s'effectuer, soit par évaporation thermique, soit par pulvérisation cathodique. On plonge ensuite le substrat 1 dans un bain d'électrolyte pour faire grossir les bandes métalliques préalablement déposées, par passage d'un courant à travers les bandes métalliques et le massif p du substrat, jusqu'à obtenir des bornes de contact 13 de quelques µm d'épaisseur.

Grâce aux bords arrondis des îlots 4, les bornes de contact 13 sont déposées sans risque de discontinuité électrique.

On procède ensuite à l'amincissement de la plaquette et au dégagement des bornes de contact 13.

A cet effet, on colle tout d'abord la plaquette 1, par sa face supérieure active présentant la structure en relief, sur une plaque-support 14, par exemple en verre, au moyen par exemple de cire 15. La plaque 14 assure la protection mécanique de la face active de la plaquette ainsi que le maintien et le positionnement de la plaquette pendant les opérations d'amincissement et de dégagement des bornes de contact.

On procède ensuite à l'amincissement de la plaquette 1, depuis sa face arrière 16 opposée à celle destinée à être éclairée, pour réduire l'épaisseur totale de la plaquette 1 de 1 mm à environ 70 à 100 µm, par des moyens connus, par exemple par rodage ou polissage mécanique ou mécano-chimique.

Enfin, on procède toujours depuis la face arrière, au dégagement des bornes 13, en attaquant le substrat jusqu'à ces bornes, celles-ci non comprises, mais la couche 10, quant à elle, comprise.

L'attaque des agents doit donc être sélective vis-à-vis des bornes. Cette attaque peut être réalisée par abrasion ionique ; dans ce cas, on cessera l'abrasion juste après l'attaque de la couche isolante 10. Cette attaque peut encore être réalisée par voie chimique ; dans ce cas, si les bornes sont par exemple en or, l'agent d'attaque peut être une solution de brome pur et d'alcool.

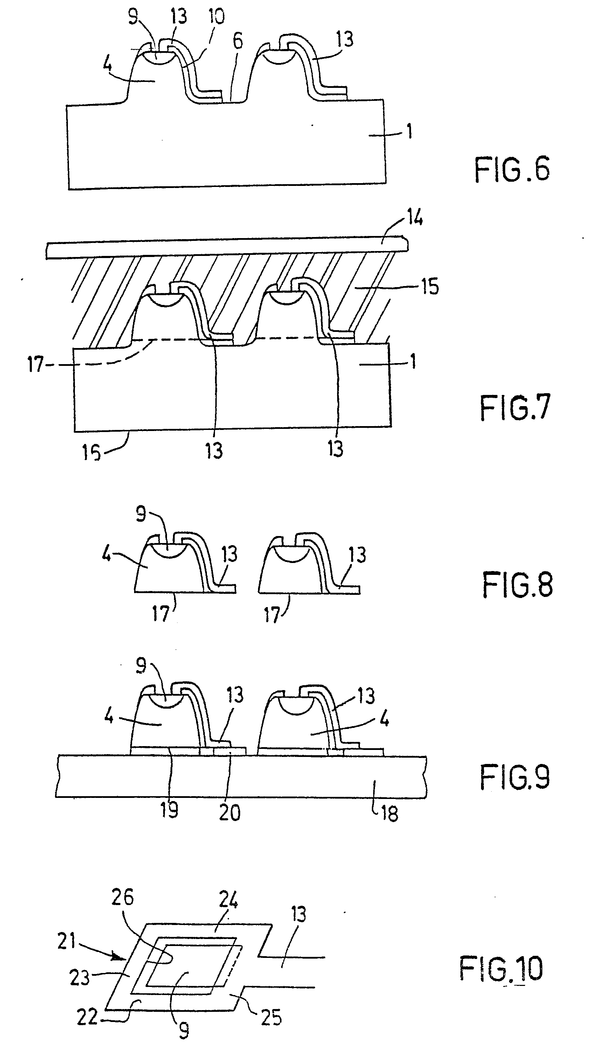

On obtient ainsi une plaquette sensiblement de même épaisseur que les îlots 4 précédemment découpés, s'étendant entre le niveau 17, correspondant sensiblement à celui des sillons 6 maintenant disparus et représenté en traits interrompus sur la figure 7, à l'épaisseur près de la couche 10 en saillie hors de l'îlot associé, également attaqué et la face supérieure destinée à être éclairée.

Il reste ensuite, après la séparation des îlots, à monter la plaquette amincie 1, ou plus exactement les différentes pièces d'îlots ainsi découpées, sur une autre plaquette de traitement 18 par sa face arrière 17, et par exemple, par collage 19, et à connecter collectivement les bornes 13, préformées et intégrées à la plaquette de détection, à la plaquette de traitement 18, et plus précisément à des plages de métallisation associées 20, par leurs pattes en saillie hors des îlots 4, toutes au même niveau que les plages 20, et à reporter ainsi les contacts n sur la plaquette de traitement. La plaquette 18 agencée pour traiter les signaux délivrés par les détecteurs de la matrice de la plaquette de détection, est de préférence en silicium, mais il ne s'agit pas ici d'une limitation de l'invention.

Le collage de la plaquette de détection sur la plaquette de traitement 18 peut être effectué à l'aide d'une colle conductrice 19. Dans ce cas, le contact de type p de la plaquette de détection est directement reporté sur la plaquette de traitement 18. Si on emploie une colle isolante, le contact p de la plaquette de détection est reporté sur la plaquette de traitement de la même manière que les contacts n.

Quant à la connexion des pattes en saillie des bornes 13 de la plaquette de détection aux plages de métallisation associées 20 de la plaquette de traitement 18, par exemple constituées d'un dépôt d'or ou d'aluminium, elle peut s'effectuer par exemple par soudure, soit aux ultrasons, soit par thermocompression, à l'aide d'un outil de soudure adapté au motif de la mosaïque de détecteurs élémentaires.

On notera que les bornes de contact 13 ont une longueur telle qu'elles descendent le long des parois des îlots et s'étendent au-delà en saillie hors de ces îlots d'une longueur nécessaire à la prise du contact sur la plage associée 20 du circuit de traitement de la plaquette 18.

Bien entendu, l'invention se rapporte à toute configuration de mosaïque, ou de matrice, de détecteurs élémentaires.

On notera aussi que pendant le dégagement des bornes de contact 13, la structure des îlots 4 évite tout risque d'infiltration de l'agent d'attaque vers les photodiodes et que les bornes elles-mêmes ne sont pas endommagées grâce à leur renforcement électrolytique.

L'intégration des bornes de contact 13 des détecteurs élémentaires de la plaquette de détection de l'invention est réalisée par formation de chacune des bornes depuis au moins une partie de la zone n associée 9. Pour améliorer l'intégration des bornes, ou encore l'ancrage des bornes, l'intégration est réalisée par une bordure fermée 21 de forme générale rectangulaire, présentant trois côtés 22, 23, 24 d'une certaine largeur, intégrés au substrat de type p, à l'extérieur de la zone n 9 associée, et un côté élargi 25 en contact avec la zone n 9 et se prolongeant en 13, vers l'extérieur de la plaquette, les côtés de la bordure 21 ménageant une fenêtre d'éclairage 26 sensiblement au droit de la zone n 9 de la jonction correspondante.

**Revendications**

1. Procédé de fabrication d'un détecteur infrarouge matriciel à éclairage par la face avant, selon lequel on forme dans une première plaquette (1) de semi-conducteur d'un premier type de conductivité depuis la face avant (8) à éclairer, un relief constitué d'îlots (4) séparés par des sillons (6), on diffuse dans le sommet des îlots (4) des zones (9) du second type de conductivité pour définir des jonctions p-n et former une matrice de détecteurs élémentaires, on dépose des bornes de contact métalliques (13) en forme de bandes, contactant lesdites zones (9) et s'étendant sur au moins l'une des parois (12) des îlots jusque dans le sillon (6) adjacent tout en étant isolées de cette paroi par une couche isolante (10), on amincit la plaquette de détection (1) depuis sa face arrière jusqu'au niveau des sillons (6) du relief et on dégage les bornes de contact (13) déposés dans ces sillons, on dispose la matrice de détecteurs, par sa face arrière de façon à établir une connection électrique (19) sur une deuxième plaquette de semi-conducteur (18) agencée pour traiter les signaux délivrés par les détecteurs élémentaires de la plaquette de détection, et on connecte lesdites bornes de contact (13) à des plages de métallisation associées (20) de la plaquette de traitement (18).

2. Procédé selon la revendication 1, dans lequel les bornes de contact (13) sont d'abord formées par l'un des deux procédés d'évaporation thermique et de pulvérisation cathodique, avant d'être grossie par voie électrolytique.

3. Procédé selon l'une des revendications 1 et 2, dans lequel on adoucit la structure des îlots (4) après leur formation en arrondissant les bords (7).

4. Procédé selon l'une des revendications 1 à 3, dans lequel, avant d'amincir la plaquette (1), on la colle (15) par sa face avant sur une plaque-support (14).

5. Procédé selon l'une des revendications 1 à 4, dans lequel on amincit la plaquette de détection de façon mécanique.

6. Procédé selon l'une des revendications 1 à 5, dans lequel on dégage les bornes de contact (13) par voie chimique.

7. Procédé selon l'une des revendications 1 à 5, dans lequel on dégage les bornes de contact (13) par abrasion ionique.

8. Procédé selon l'une des revendications 1 à 7, dans lequel on dispose la plaquette de détection (1, 4) sur la plaquette de traitement (18) par collage.

9. Procédé selon l'une des revendications 1 à 8, dans lequel on part d'une plaquette en Hg Cd Te.

## Claims

1. Process for manufacturing a matrix infrared detector with front face illumination, which comprises forming on a first semi-conductor wafer (1) of one conductivity type, from the front face (8) to be illuminated, a relief formed with islets (4) separated by furrows (6), diffusing into the top level of the islets (4) zones (9) of the second conductivity type in order to define p-n junctions and to form a matrix of elementary detectors, depositing metallic strip shaped contact terminals (13), contacting said zones (9) and extending over at least one of the walls (12) of the islets up to the adjacent furrow (6) while being isolated from said wall by an insulating layer (10), thinning the detecting wafer (1) from its rear face up to the furrows (6) of the relief and clearing the contact terminals (13) deposited in these furrows, disposing the matrix of detectors, by its rear face, in order to set up an electrical connection (19), on a second semi-conductor wafer (18) adapted to process the signals delivered by the elementary detectors of the detecting wafer, and connecting said contact terminals (13) to associated metallization zones (20) of the processing wafer (18).

2. Process of claim 1, wherein the contact terminals (13) are firstly formed by one of the two processes of thermal evaporation and cathode sputtering process, before being enlarged by an electrolytic process.

3. Process of one of claims 1 and 2, wherein the structure of the islets (4) is smoothed after they have been formed by rounding the edges (7).

4. Process of one of claims 1 to 3, wherein, before the wafer (1) is thinned, it is glued (15) by its front face on a support plate (14).

5. Process of one of claims 1 to 4, wherein the detection wafer is thinned by mechanical means.

6. Process of one of claims 1 to 5, wherein the contact terminals (13) are cleared by a chemical process.

7. Process of one of claims 1 to 6, wherein the contact terminals (13) are cleared by ionic abrasion.

8. Process of one of claims 1 to 7, wherein the detection wafer (1, 4) is disposed on the processing wafer (18) by gluing.

9. Process of one of claims 1 to 8, wherein a starting wafer composed of Hg Cd Te is provided.

## Patentansprüche

1. Verfahren zur Herstellung eines auf der Vorderseite zu bestrahlenden, matritzenförmigen Infrarotdetektors, bei dem man in ein erstes Hableiterplättchen (1) eines ersten Leitfähigkeitstypes von der zu bestrahlenden Vorderseite (—) aus ein Releif, das aus durch Furchen (6) voneinander getrennten Inseln (4) gebildet ist, einarbeitet, dann, um p-n-Übergänge zu erhalten und eine Matrize von Elementardetektoren herzustellen, in die Oberseiten der Inseln (4) Zonen (9) des zweiten Leitfähigkeitstypes hineindiffundiert, danach mit den Zonen (9) in Kontakt stehende, streifenförmige, metallische Kontaktanschlüsse (13), die sich mindestens entlang einer Seitenwand (12) der Inseln bis in den Bereich der angrenzenden Furche (6) erstrecken, wobei sie gegenüber der jeweiligen Seitenwand durch eine Isolierschicht (10) isoliert sind, ablagert, anschließend das Detektorplättchen (1) von seiner Rückseite aus bis zum Niveau der Furchen (6) des Reliefs verdünnt und die Kontaktanschlüsse (13), die in diesen Furchen abgelagert sind, freilegt, dann die Detektorenmatrize mit ihrer Rückseite derart, daß eine elektrische Verbindung hergestellt wird, auf ein zweites Halbleiterplättchen (18) auflegt, das in der Lage ist, die von den Elementardetektoren des Detektorplättchens gelieferten Signale zu verarbeiten, und anschließend die Kontaktanschlüsse (13) mit entsprechenden metallisierten Bereichen (20) des Verarbeitungsplättchen (18) verbindet.

2. Verfahren nach Anspruch 1, bei dem die Kontaktanschlüsse (13) zuerst durch eines der beiden Verfahren der thermischen Verdampfung oder der Kathodenzerstäubung gebildet werden, bevor sie auf elektrolytischem Wege vergrößert werden.

3. Verfahren nach einem der Ansprüche 1 und 2, bei dem man die Struktur der Inseln (4) nach ihrer Bildung durch Abrunden ihrer Ränder (7) entgrätet.

4. Verfahren nach einem der Ansprüche 1 bis 3, bei dem man das Plättchen (1), bevor man es dünner macht, mit seiner Vorderseite auf einer Stützplatine (14) festklebt (15).

5. Verfahren nach einem der Ansprüche 1 bis 4, bei dem man das Detektorplättchen auf mechanischem Wege dünner macht.

6. Verfahren nach einem der Ansprüche 1 bis 5, bei dem man die Kontaktanschlüsse (13) auf chemischem Wege freilegt.

7. Verfahren nach einem der Ansprüche 1 bis 5, bei dem man die Kontaktanschlüsse (13) durch Ionenabtragung freilegt.

8. Verfahren nach einem der Ansprüche 1 bis 7, bei dem man das Detektorplättchen (1, 4) durch Festkleben auf dem Verarbeitungsplättchen (1, 4) durch Festkleben auf dem Verarbeitungsplättchen (18) aufbringt.

9. Verfahren nach einem der Ansprüche 1 bis 8, bei dem man von einem HgCdTe-Plättchen ausgeht.

FIG.1

FIG.2

FIG.3

FIG.4

FIG.5

0 116 791

FIG.6

FIG.7

FIG.8

FIG.9

FIG.10

2